## Europäisches Patentamt

## European Patent Office

## Office européen des brevets

(19)

(11) **EP 0 895 671 B1**

(12)

# FASCICULE DE BREVET EUROPEEN

| | |
|---|---|
| (45) Date de publication et mention de la délivrance du brevet: **14.02.2001 Bulletin 2001/07** | (51) Int Cl.⁷: **H03K 17/18** |
| (21) Numéro de dépôt: **97920787.5** | (86) Numéro de dépôt international: **PCT/FR97/00705** |
| (22) Date de dépôt: **18.04.1997** | (87) Numéro de publication internationale: **WO 97/40578 (30.10.1997 Gazette 1997/46)** |

(54) **RELAIS STATIQUE AVEC DETECTION D'ETAT**

**STATISCHES RELAIS MIT ZUSTANDSERKENNUNG**

**STATIC RELAY WITH CONDITION DETECTING**

| | |
|---|---|
| (84) Etats contractants désignés: **BE CH DE DK ES FR GB IT LI LU NL SE** | (72) Inventeur: **BLAIN, Gérard, Jean** **F-94117 Arcueil Cédex (FR)** |
| (30) Priorité: **22.04.1996 FR 9605016** | (74) Mandataire: **Guérin, Michel et al** **Thomson-CSF Propriété Intellectuelle,** **13, Avenue du Président Salvador Allende** **94117 Arcueil Cédex (FR)** |
| (43) Date de publication de la demande: **10.02.1999 Bulletin 1999/06** | |
| (73) Titulaire: **CROUZET Automatismes** **26000 Valence (FR)** | (56) Documents cités: **EP-A- 0 348 637 EP-A- 0 511 028 DE-A- 3 311 426 US-A- 4 757 417 US-A- 4 929 932 US-A- 5 493 101** |

**Description**

L'invention concerne les relais statiques utilisés pour effectuer l'ouverture ou la fermeture des circuits électriques.

Un tel relais selon le préambule de la revendication 1 est connu de la demande de brevet EP-A-0 511 028.

Actuellement, on rencontre au moins deux principaux types de relais selon leurs technologies de réalisation, les relais électromécaniques et les relais à semi-conducteurs ou relais statiques. Les relais de type électromécanique comportent un ou plusieurs contacts électriques couplés mécaniquement à un élément mobile d'un circuit magnétique actionné par la commande de l'alimentation d'une bobine produisant un flux d'induction dans le circuit magnétique. Le circuit magnétique est ouvert ou fermé selon la position de son élément mobile. Par exemple le relais est en position repos, la bobine du relais n'est pas alimentée, le circuit magnétique de la bobine du relais est ouvert et les contacts électriques du relais sont ouverts. Le changement d'état du relais est réalisé en alimentant la bobine du relais par un courant électrique de commande, le circuit magnétique se ferme, entraînant la fermeture des contacts électriques. Le relais passe d'une position de repos à une position de travail.

L'état du relais électromécanique peut être rapidement déterminé, soit par la visualisation de l'entrefer, entre une partie fixe et l'élément mobile du circuit magnétique, soit par le bruit de commutation du relais après un changement d'état en supposant que l'état initial était connu.

Les relais statiques contrairement aux relais électromécaniques n'utilisent pas d'éléments mécaniques mobiles mais des semi-conducteurs capables d'effectuer l'ouverture ou la fermeture d'un circuit électrique dans lesquels ils sont insérés. Généralement pour des raisons de sécurité le circuit de commande est isolé galvaniquement du circuit électrique dans lequel le relais est inséré, certains circuits électriques mettant en jeu des courants et des tensions élevées. Par exemple pour les relais statiques, l'isolement de la commande est réalisée par photocoupleur. Les relais statiques connectés à un circuit électrique fonctionnant en courant alternatif, utilisent des semi-conducteurs tels que les triacs ou les thyristors montés en parallèle tête-bêche, ou des composants analogues tels que ceux commercialisés sous les dominations "Snubberless" ou "alternistor" qui fonctionnent comme des triacs et ont une meilleure tenue aux déclenchements intempestifs.

Ces types de semi-conducteurs, présentent dans leur fonctionnement normal, deux états différents lorsqu'ils sont insérés dans un circuit électrique. Un état ouvert et un état fermé. Dans l'état ouvert, toute la tension du circuit électrique se trouve appliquée aux bornes du semi-conducteur. Dans l'état fermé (ou saturé), il apparaît aux bornes du semi-conducteur une tension de saturation d'environ 1,5 Volt alternatif.

Les relais statiques peuvent présenter un autre état supplémentaire qui n'est pas un état habituel de fonctionnement et qui est lié à la destruction du semi-conducteur, se mettant alors, soit en court-circuit, soit en circuit ouvert. Lorsque le semi-conducteur est détruit et il se présente comme court-circuit, la tension à ses bornes est pratiquement égale à 0 Volt et lorsqu'il se présente comme un circuit ouvert, toute la tension du circuit électrique est présente à ses bornes.

Les automatismes utilisent très couramment des relais et particulièrement des relais statiques qui tendent à remplacer les relais électromécaniques de technologie ancienne et il est nécessaire de connaître l'état réel du relais en fonction de l'état de sa commande. Actuellement deux cas peuvent se présenter, soit le relais ne fournit aucune information de son état, soit on détermine son état à l'aide de systèmes externes au relais.

Par exemple en faisant l'hypothèse que le relais n'est pas défectueux ou en panne, une mesure de courant du circuit électrique dans lequel le relais est inséré, permet de déterminer si le relais est ouvert ou fermé, ceci nécessite un dispositif de mesure pouvant supporter la totalité du courant du circuit électrique. Ce dispositif de mesure est coûteux et encombrant en particulier dans le cas de circuits électriques mettant en jeu de fortes puissances. Dans le cas de relais statiques à semi-conducteurs, la mesure de la tension aux bornes du relais peut être effectuée afin de déterminer son état. Lorsque le relais est ouvert toute la tension du circuit électrique se trouve appliquée à ses bornes et lorsqu'il est fermé, on doit pouvoir détecter une tension de l'ordre de 1,5 Volt correspondant à la tension de saturation du semi-conducteur. Le dispositif de mesure de tension aux bornes du relais doit d'une part supporter les tensions des circuits électriques parfois élevées de quelques centaines et voire de milliers de Volts et d'autre part avoir une précision suffisante pour détecter la faible tension de saturation du semi-conducteur d'environ 1,5 Volt. Ceci conduit à un appareillage de mesure trop coûteux et difficile à mettre en oeuvre.

Pour pallier ces inconvénients de l'art antérieur l'invention propose un relais statique (RS) destiné à être inséré dans un circuit électrique à courant alternatif (CE) comportant au moins deux bornes (1,2) de branchement, le relais statique (RS) ayant au moins un composant semi-conducteur, pouvant prendre deux états en phase de fonctionnement l'un ouvert et l'autre fermé, des moyens de détermination de l'état du relais (RS) en phase de fonctionnement et d'un état supplémentaire correspondant notamment au relais détruit, au circuit électrique (CE) hors tension, au relais débranché, ces moyens étant connectés aux bornes du relais, les moyens de détermination de l'état du relais comportant une paire de diodes électroluminescentes (D1, D2) montées en parallèle tête-bêche, cette paire étant en série avec un circuit de type RC série (R1,C), l'ensemble diodes (D1, D2) et circuit RC(R1, C) étant connecté en parallèle sur le composant semi-conducteur (Th1, Th2) et chaque diode (D1, D2) étant couplée optiquement respectivement à un transistor (T1, T2), une des diodes étant parcourue par un courant lié à l'alternance positive de la tension alternative du circuit électrique et l'autre diode étant parcourue par un courant lié à l'alternance négative du même circuit électrique. Les diodes électroluminescentes sont allumées pendant la quasi totalité des alternances lorsque le composant est ouvert et non défectueux. Ces mêmes diodes sont allumées pendant un court instant au passage par le niveau zéro des alternances lorsque le composant est fermé et non défectueux.

Les diodes restent éteintes pendant la totalité des alternances lorsque le composant est défectueux et en court circuit.

D'autres caractéristiques et avantages de l'invention apparaîtront à la lecture de la description d'exemples de relais selon l'invention dans laquelle :

- la figure 1a représente le schéma électrique du relais statique selon l'invention et la figure 1b une variante du semi-conducteur du relais ;
- la figure 1c représente une variante des moyens de détermination de l'état du relais ;
- les figures 2a, 2b et 2c représentent les diagrammes de tension et de courant du relais faisant l'objet de la figure 1a dans l'état ouvert ;
- les figures 3a, 3b, 3c représentent les diagrammes de tension et de courant du relais faisant l'objet de la figure 1a dans l'état fermé ;
- les figures 4a et 4b représentent les diagrammes de tension et de courant du relais faisant l'objet de la figure 1a dans l'état supplémentaire, lorsque le semi-conducteur est en court-circuit ;
- les figures 5a, 5b et 5c représentent les diagrammes de tension et de courant du relais faisant l'objet de la figure 1a dans un autre état supplémentaire, le relais étant en position fermé.

Sur les diagrammes les échelles ne sont pas forcément respectées dans un souci de clarté.

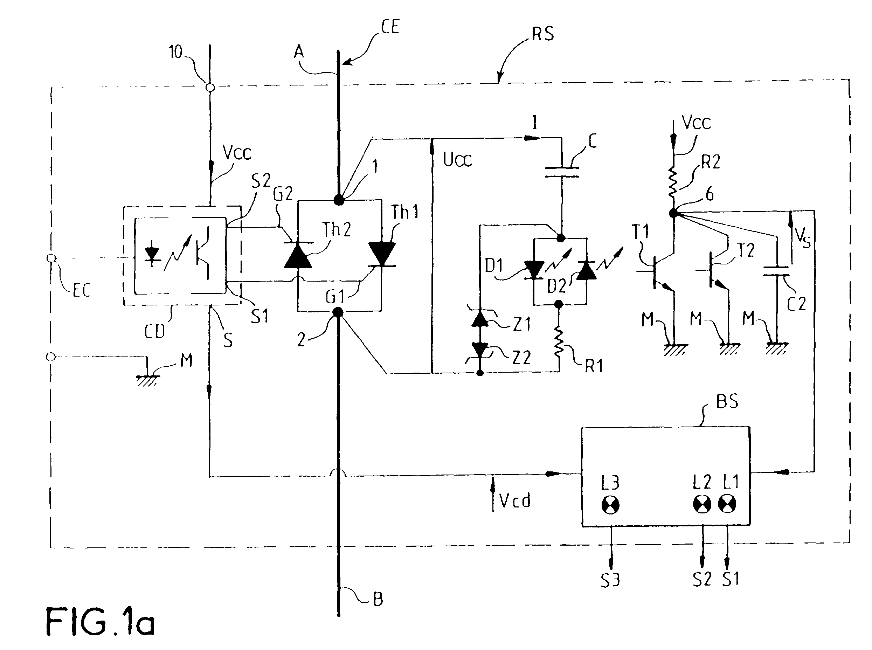

La figure 1a montre le schéma électrique d'un exemple de réalisation d'un relais statique RS selon l'invention, comportant une paire de thyristors Th1 et Th2 connectés en parallèle tête-bêche. La cathode du thyristor Th2 est connectée à l'anode du thyristor Th1 et à une borne 1 du relais RS elle-même connectée à un premier côté A d'un circuit électrique CE et la cathode du thyristor Th1 est connectée à l'anode du thyristor Th2 et à une borne 2 du relais RS elle-même connectée à un second côté B du circuit électrique CE. La tension apparaissant aux bornes des thyristors lorsque le circuit électrique CE est sous tension, sera désignée par la suite par Ucc.

Le relais RS est commandé par une entrée de commande EC d'un circuit de commande CD qui envoie selon l'art connu par ses sorties de commande S1 et S2 sur les gâchettes respectives G1 et G2 des thyristors Th1 et Th2 des signaux électriques déclenchant la fermeture de ces thyristors. Le circuit de commande CD intègre une isolation optique afin d'isoler l'entrée EC du relais, des thyristors qui se trouvent à la tension du circuit électrique CE.

Les moyens de détermination de l'état du relais comportent une paire de diodes électroluminescentes D1, D2 montées en parallèle tête-bêche, cette paire de diodes étant en série avec un circuit de type RC série R1,C, l'ensemble paire de diodes D1, D2 et circuit RC étant connecté en parallèle sur la paire de thyristors Th1,Th2 et chaque diode D1, D2 étant couplée optiquement respectivement à un transistor T1, T2.

Le relais RS comporte une entrée 10 connectée à une source d'alimentation externe au relais, de tension d'alimentation Vcc permettant d'alimenter en courant continu d'une part le circuit de commande CD du relais et d'autre part les moyens de détermination de l'état du relais RS.

Les collecteurs des transistors T1 et T2 sont connectés ensemble sur une borne 6 et reliés d'une part à la tension d'alimentation Vcc par l'intermédiaire d'une résistance R2 et d'autre part à une masse commune M, par l'intermédiaire d'un condensateur C2.

Les émetteurs des transistors T1 et T2 sont connectés à la masse commune M.

L'information d'état du relais RS est obtenue par la tension Vs en sortie des collecteurs des transistors T1 et T2 (borne 6).

Il est préférable de placer un limiteur de tension, comportant dans cet exemple de réalisation, deux diodes Zener Z1 et Z2 montées en série tête-bêche, aux bornes du sous-ensemble constitué par la paire de diodes électroluminescentes D1 et D2 et la résistance R1. Ce limiteur Z1, Z2 permet de protéger les diodes électroluminescentes D1 et D2 en cas de front raide de forte amplitude de la tension Ucc aux bornes des thyristors, par exemple dû au déclenchement des thyristors lorsque la tension Ucc est à niveau élevé.

On va décrire maintenant le fonctionnement du relais RS. Le relais RS est inséré dans un circuit électrique CE supposé fonctionnant à une tension électrique U alternative, par exemple sinusoïdale. On considère le cas où le relais est en position ouverte c'est-à-dire que les thyristors Th1 et Th2 sont ouverts.

On se réfère pour expliquer le fonctionnement aux figures la, 2a, 2b et 2c représentant le schéma électrique du relais inséré dans le circuit électrique CE et les diagrammes de tension et courant dans les circuits du relais RS.

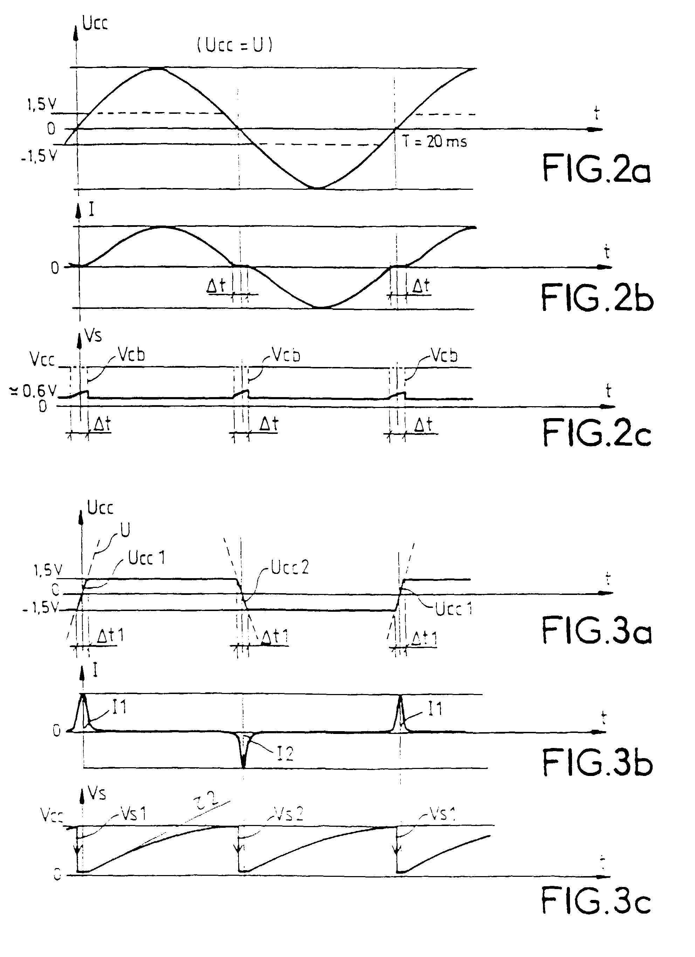

Le relais RS étant mis en position ouverte par la commande EC, toute la tension U du circuit électrique se trouve appliquée aux bornes des thyristors (bornes 1 et 2 du relais RS) et dans ce cas, Ucc est égale à la tension U du circuit électrique CE. Le diagramme de la figure 2a montre la tension Ucc en fonction du temps aux bornes des thyristors.

Si l'on considère un circuit électrique fonctionnant en courant alternatif à la fréquence de 50 Hz, la période T de la tension Ucc sera de 20 ms.

Le diagramme de la figure 2b montre la forme du courant I dans le circuit constitué par le condensateur C, les diodes électroluminescentes D1 et D2 et la résistance R1.

Le courant I est de forme proche d'un courant sinusoïdal. Le courant I traverse la diode électroluminescente D1 pendant une demi-alternance et la diode électroluminescente D2 pendant l'autre demi-alternance produisant alternativement la saturation du transistor T1 puis du transistor T2 et ainsi de suite, sauf pendant une courte période de temps $\Delta t$ par rapport à la période de la tension Ucc correspondant à l'annulation du courant I dans les diodes D1 et D2, dû au seuil (d'environ 1,2 Volt) de conduction des diodes D1 et D2, au moment du passage par 0 Volt de la tension Ucc.

Pendant environ ce court laps de temps $\Delta t$, les transistors T1 et T2 sont bloqués et la tension Vs aux bornes de ses collecteurs, représentée en pointillés sur la figure 2c, tends à passer d'une façon brusque, pendant le temps $\Delta t$, au niveau de la tension d'alimentation Vcc. La figure 2c représente en pointillés une tension Vcb qui apparaîtrait sur les collecteurs des transistors T1,T2, pendant $\Delta t$, dans le cas où un condensateur C2 ne serait pas connecté sur les collecteurs des transistors. Le circuit de type RC, R2, C2 est chargé d'intégrer les variations de la tension Vcb pendant le laps de temps $\Delta t$.

Les valeurs de R2 et C2 sont calculées pour maintenir cette variation de Vcb à une valeur faible, proche de la tension de saturation des transistors. La tension Vs à la borne 6, point de connexion des collecteurs des deux transistors T1 et T2 est maintenue sensiblement égale à la tension de saturation des transistors soit environ 0,6 Volt. On dira que la tension Vs est à un état bas.

Le circuit de type RC constitué par les composants C et R1 est calculé de façon à assurer un courant I suffisant pour saturer les transistors T1 et T2.

Dans cet exemple de réalisation le condensateur C est d'environ 10 nF et la résistance R1 d'environ 47 $\Omega$.

Le relais est mis en position fermée (ou saturée), on se réfère pour l'explication de cette phase de fonctionnent aux figures 1a, 3a, 3b et 3c.

La fermeture du relais RS par une commande de son entrée EC, entraîne la fermeture du circuit électrique CE. Le courant alternatif parcourant le circuit électrique fait apparaître aux bornes des thyristors Th1 et Th2 une tension de saturation qui est de l'ordre de 1,5 Volt pour ce type de semi-conducteur.

Le diagramme de la figure 3a montre la forme de la tension Ucc aux bornes des thyristors (bornes 1 et 2).

La tension Ucc suit dans une première phase, la tension U, sinusoïdale du circuit électrique, représentée partiellement en pointillés à la figure 3a et elle se stabilise autour de la valeur de la tension de saturation des thyristors. Pendant la demi période positive Th1 se ferme et la tension Ucc entre les bornes 1 et 2 est de l'ordre de 1,5 Volt et pendant l'autre demi période négative, l'autre thyristor Th2 se ferme et la tension Ucc est de l'ordre de -1,5 Volt.

Le courant I dans le condensateur C est lié à la variation de la tension aux bornes du circuit RC comportant le condensateur C les diodes D1 et D2 et la résistance R1 soit à $\frac{dUcc}{dt}$. Le courant I apparaît sous forme impulsionnelle pendant les fronts de montée ou de descente de la tension Ucc autour de 0 Volt et pendant un temps $\Delta t1$, court par rapport à la période et dépendant de la valeur de la tension dans le circuit électrique (courbe en pointillés sur la figure 3a) par rapport à la tension de saturation des thyristors.

La figure 3b montre le courant I impulsionnel dans le condensateur C, l'impulsion de courant I1 se produisant pendant le front de monté Ucc1 de la tension Ucc, traverse la diode D1 provoquant une saturation, pendant environ $\Delta t1$, du transistor T1 couplé optiquement à la diode D1 et une décharge instantanée du condensateur C2 monté entre les collecteurs des transistors T1 et T2 et la masse M. Ceci se traduit par un front de descente raide Vs1 (figure 3c) de la tension Vs des collecteurs des transistors T1 et T2 puis une charge du condensateur C2, vers la tension d'alimentation Vcc appliquée à la résistance R2, avec une constante de temps $\tau_2$ = R2 x C2.

Par exemple dans cette réalisation la résistance R2 est d'environ 33 K$\Omega$ et le condensateur C2 est d'environ 200 nF. La constante de temps $\tau_2$ est égale à environ 7,26 ms.

De la même façon pendant le front de descente Ucc2 (figure 3a) de la tension Ucc se produisant à la demi période suivante autour d'une tension Ucc de 0 Volt, le courant impulsionnel I2 traverse l'autre diode électroluminescente D2 provoquant une saturation, pendant environ un temps $\Delta t1$, du transistor T2 couplé optiquement à la diode électroluminescente D2 et de la même façon que pour la demi période précédente une décharge instantanée de la capacité C2 se traduisant par un front de descente raide Vs2 de la tension Vs des collecteurs des transistors T1 et T2 puis une nouvelle charge du condensateur C2 vers la tension Vcc appliquée à la résistance R2.

L'état ouvert du relais RS est déterminé par une succession de fronts de descente (Vs1, Vs2 ...) de la tension Vs toutes les demi périodes, soit pour un circuit électrique alternatif fonctionnant à 50 Hz, toutes les 10 ms.

On va envisager le cas où les moyens de détection d'état indiquent l'état supplémentaire. Cela se produit notamment lorsque un ou les deux thyristors sont détruits ou lorsque le circuit électrique est hors tension ou même lorsque le relais est débranché.

Dans les cas qui suivent, on se réfère pour l'explication du fonctionnement au relais de la figure 1a.

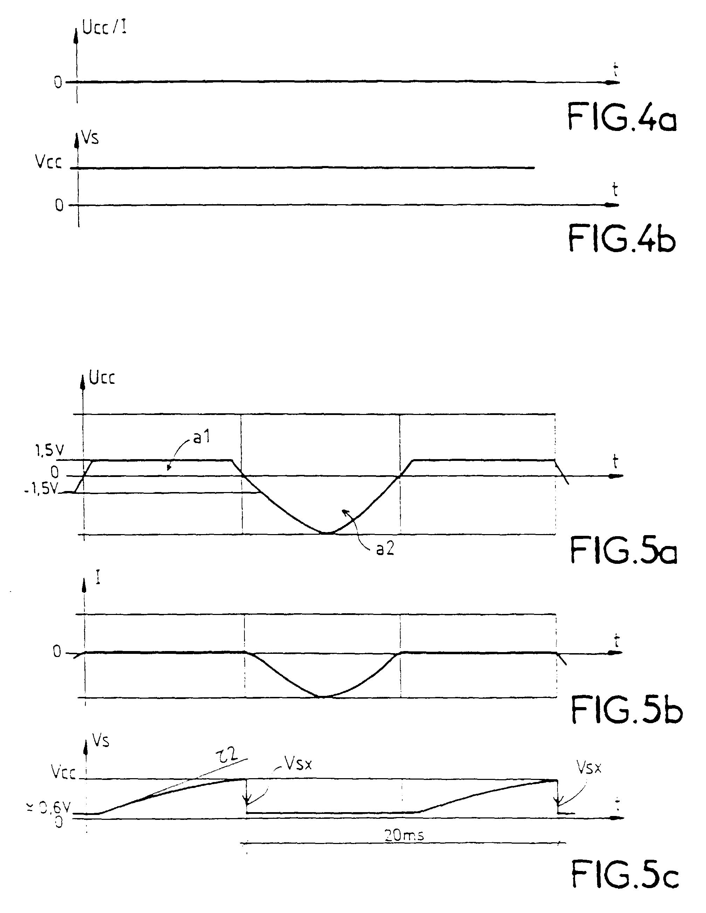

Dans les cas où les deux thyristors sont détruits et en court-circuit ou lorsque le circuit électrique est hors tension ou même lorsque le relais est débranché seulement du circuit électrique CE (bornes 1 et 2), la tension Ucc aux bornes des thyristors, représentée à la figure 4a, est sensiblement égale à 0 Volt. Les transistors T1 et T2 sont bloqués par absence de courant I (représenté à la figure 4a) dans les diodes électroluminescentes D1 et D2, les collecteurs des transistors T1 et T2 sont bloqués et la tension de sortie Vs, représentée à la figure 4b, est à la tension d'alimentation Vcc, soit à l'état haut.

Dans un autre cas, le relais RS, commandé par son entrée EC, est dans un état fermé et un des thyristors, par exemple le thyristor Th2 est détruit et en circuit ouvert. Pendant une première alternance a1 de la tension Ucc, le thyristor Th1 est fermé et permet le passage du courant du circuit électrique CE. La tension Ucc, représentée à la figure 5a est de l'ordre de 1,5 Volt correspondant à la tension de saturation du thyristor Th1. Le courant I, représenté à la figure 5b, dans le circuit comportant la paire des diodes D1,D2 est nul pendant cette première alternance a1. Les transistors T1 et T2 sont bloqués et la tension Vs, représentée à la figure 5c, qui se trouvait à un état bas, pendant l'alternance précédente, comme cela sera montré par la suite, passe avec la constante de temps $\tau_2$ (résistance R2, condensateur C2) de 0 Volt à la tension d'alimentation Vcc, comme dans le cas de la figure 3c.

Pendant l'alternance suivante a2, la tension Ucc change de sens et le thyristor Th1 qui était fermé pendant l'alternance précédente a1, devient ouvert dans un fonctionnement normal et toute la tension du circuit électrique CE se trouve appliquée aux bornes des thyristors. Un courant I apparaît dans une des diodes de la paire de diodes D1,D2 saturant un des transistors T1,T2 qui entraîne alors la décharge instantanée du condensateur C2 et un passage avec un front raide Vsx de la tension Vs, du niveau Vcc au niveau de saturation du transistor saturé, soit environ 0,6 Volt. La tension Vs reste à environ 0,6 Volt pendant toute l'alternance a2, soit à l'état bas.

Le signal Vs présente un front de descente raide Vsx toutes les périodes. Par exemple toutes les 20 ms dans le cas d'un circuit électrique fonctionnant à 50 Hz.

La tension Vs en sortie des moyens de détermination de l'état du relais RS aura les caractéristiques récapitulées suivantes :

| Etats du relais | Tension Vs |
|---|---|
| ouvert | Vs $\simeq$ 0,6 Volt (état bas) |
| fermé | Vs : front descendant Vs1, Vs2 (de Vcc à $\simeq$ 0,6 Volt) toutes les demi périodes |
| Supplémentaire : | |
| 1 - Thyristors détruits et en court-circuit ou lorsque le circuit électrique est hors tension ou même lorsque le relais est débranché seulement du circuit électrique CE (bornes 1 et 2) | Vs = Vcc (état haut) |
| 2 - Relais RS à l'état fermé, un thyristor détruit et en circuit ouvert | Vs : front descendant Vsx (de Vcc à $\simeq$ 0,6 Volt) toutes les périodes |

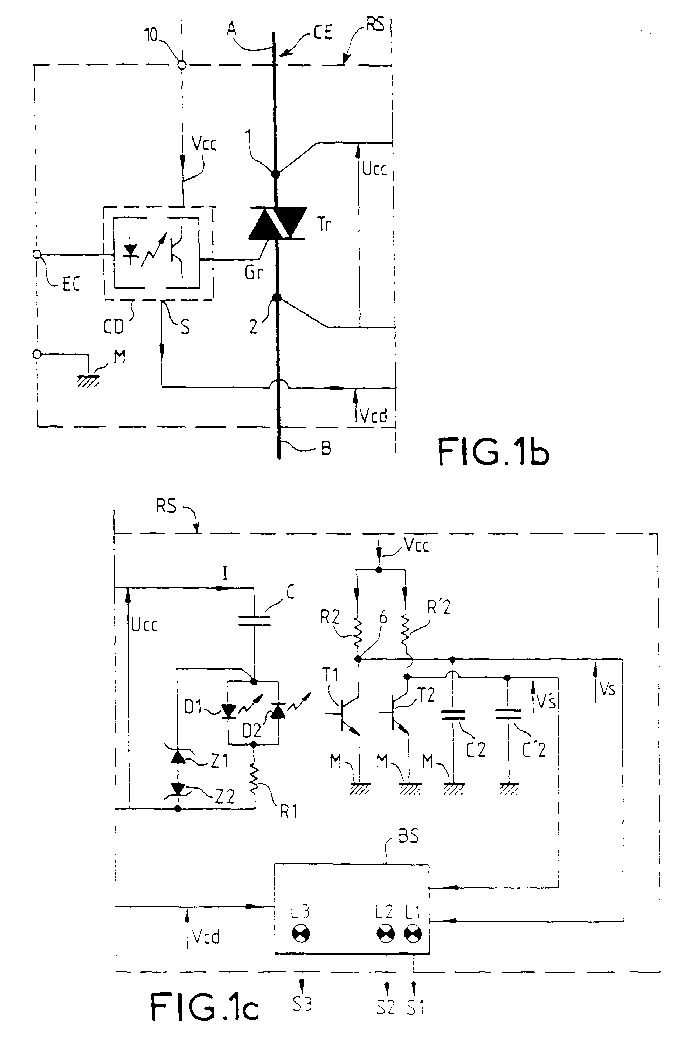

Dans une autre réalisation du relais statique avec détection d'état, représentée à la figure 1b, le composant semi-conducteur est un triac Tr. Ce semi-conducteur comporte une seule gâchette Gr. Le déclenchement du triac soit pendant l'alternance positive, soit pendant l'alternance négative de la tension alternative appliquée à ses bornes, s'effectue par son unique gâchette. Dans ce cas, le circuit de commande sera, selon l'art connu, adapté à ce type de semi-conducteur.

Dans une autre réalisation montrée à la figure 1c, les moyens de détermination de l'état du relais RS comportent les deux transistors T1 et T2, le collecteur du transistor T1 est relié d'une part à la tension d'alimentation Vcc par l'intermédiaire d'une résistance R2 et d'autre part à la masse commune M, par l'intermédiaire d'un condensateur C2. Le collecteur du transistor T2 est relié d'une part à la tension d'alimentation Vcc par l'intermédiaire d'une résistance R'2 et d'autre part à la masse commune M par l'intermédiaire d'un condensateur C'2, les émetteurs des transistors T1,T2, étant connectés à la masse commune M.

Deux informations Vs et V's en sortie respective des collecteurs des transistors T1 et de T2 représentent respectivement l'état du relais correspondant à l'une et à l'autre des alternances du circuit électrique CE.

L'état de commande correspondant à la tension Vcd en sortie S (figure 1a) du circuit de commande CD et les différents états de la tension de sortie Vs correspondant aux états ouvert, fermé ou supplémentaire sont traités par un système BS électronique connu pour être mis en forme par exemple par bascules ou monostables, générant des informations séparées de l'état du relais. On peut, par exemple, allumer des diodes électroluminescentes L1, L2, L3 correspondant aux états du relais et/ou générer des informations d'état S1, S2, S3 en sortie du système BS pour être traitées par un circuit informatique qui pourra tenir compte d'autres paramètres du relais, comme l'état de son entrée de commande EC ou des paramètres externes au relais comme par exemple, la présence ou l'absence de tension dans le circuit électrique CE.

Les possibilités de traitement du signal Vs (et V's à la figure 1c) en sortie du relais décrites dans ce document ne sont pas limitatives d'autres traitements et des combinaisons avec des signaux externes ou relais, conduisent une parfaite détermination de l'état du relais ou de l'état d'un ensemble de relais faisant partie d'un système automatique.

## Revendications

1.  Relais statique (RS) destiné à être inséré dans un circuit électrique à courant alternatif (CE) comportant au moins deux bornes (1,2) de branchement, le relais statique (RS) ayant au moins un composant semi-conducteur, pouvant prendre deux états en phase de fonctionnement l'un ouvert et l'autre fermé, des moyens de détermination de l'état du relais (RS) en phase de fonctionnement et d'un état supplémentaire correspondant notamment au relais détruit, au circuit électrique (CE) hors tension, au relais débranché, ces moyens étant connectés aux bornes du relais et comportant une paire de diodes électroluminescentes (D1, D2) montées en parallèle têtebêche, chaque diode (D1, D2) étant couplée optiquement respectivement à un transistor (T1, T2), une des diodes étant parcourue par un courant lié à l'alternance positive de la tension alternative du circuit électrique et l'autre diode étant parcourue par un courant lié à l'alternance négative du même circuit électrique, les diodes électroluminescentes étant allumées pendant la quasi totalité des alternances lorsque le composant est ouvert et non défectueux, les diodes restant éteintes pendant la totalité des alternances lorsque le composant est défectueux et en court circuit caractérisé en ce que cette paire est en série avec un circuit de type RC série (R1,C), l'ensemble diodes (D1, D2) et circuit RC(R1, C) étant connecté en parallèle sur le composant semi-conducteur (Th1, Th2), les diodes étant allumées pendant un court instant au passage par le niveau zéro des alternances lorsque le composant est fermé et non défectueux.

2.  Relais statique selon la revendication 1, caractérisé en ce que le semi-conducteur comporte deux thyristors (Th1, Th2).

3.  Relais statique selon la revendication 1, caractérisé en ce que le semi-conducteur est un triac.

4.  Relais statique selon la revendication 2, caractérisé en ce qu'il comporte deux thyristors (Th1, Th2) connectés en parallèle tête-bêche aux bornes du relais.

5.  Relais statique selon l'une quelconque des revendications 1 à 4, caractérisé en ce qu'il est équipé d'un circuit de commande (CD) du semi-conducteur (Th1, Th2) de telle façon à effectuer un déclenchement du semi-conducteur lorsque la tension aux bornes du relais passe sensiblement à 0 Volt.

6.  Relais statique selon l'une quelconque des revendications 1 à 5, caractérisé en ce qu'un limiteur de tension (Z1, Z2) est branché en parallèle avec le sous-ensemble formé par les diodes électroluminescentes (D1,D2) et la résistance (R1) du circuit de type RC.

7.  Relais statique selon la revendication 6, caractérisé en ce que le limiteur comporte deux diodes Zener (Z1, Z2) montées en série tête-bêche.

8.  Relais statique selon l'une quelconque des revendications 1 à 7, caractérisé en ce que les collecteurs des transistors (T1,T2) sont connectés ensemble (6) et reliés d'une part à une tension d'alimentation (Vcc) par l'intermédiaire d'une résistance (R2) et d'autre part à une masse commune (M) par l'intermédiaire d'un condensateur (C2), les émetteurs des transistors (T1, T2) étant connectés à la masse commune (M).

9.  Relais statique selon l'une quelconque des revendications 1 à 7, caractérisé en ce que le collecteur de chaque transistor (T1,T2), est relié d'une part à la tension d'alimentation (Vcc) par l'intermédiaire d'une résistance (R2,R'2) et d'autre part à une masse commune (M) par l'intermédiaire d'un condensateur (C2,C'2), les émetteurs des transistors (T1,T2) étant connectés à la masse commune (M).

10. Relais statique selon l'une quelconque des revendications 1 à 9, caractérisé en ce que le relais statique est équipé d'un système (BS) effectuant la mise en forme et/ou la transmission à l'extérieur du relais (RS) des informations d'état (S1,S2,S3) du relais.

**Patentansprüche**

1. Statisches Relais (RS), das dazu vorgesehen ist, in eine elektrische Wechselstromschaltung (CE) eingesetzt zu werden, die wenigstens zwei Anschlußklemmen (1, 2) enthält, wobei das statische Relais (RS) wenigstens ein Halbleiterbauelement, das zwei Betriebszustände, einen geöffneten und einen geschlossenen, annehmen kann, sowie Mittel besitzt, die den Betriebszustand des Relais (RS) und einen zusätzlichen Zustand bestimmen, der insbesondere dem zerstörten Relais, der spannungslosen elektrischen Schaltung (CE) oder dem abgetrennten Relais entspricht, wobei diese Mittel an die Anschlußklemmen des Relais angeschlossen sind und ein Paar Elektrolumineszenz-Dioden (D1, D2) umfassen, die parallel und zueinander entgegengesetzt geschaltet sind, wobei jede Diode (D1, D2) optisch mit einem Transistor (T1, T2) gekoppelt ist, wobei eine der Dioden von einem Strom durchflossen wird, der mit der positiven Halbperiode der Wechselspannung der elektrischen Schaltung in Beziehung steht, und die andere Diode von einem Strom durchflossen wird, der mit der negativen Halbperiode dieser elektrischen Schaltung in Beziehung steht, wobei die Elektrolumineszenz-Dioden nahezu während der gesamten Halbperioden erleuchtet sind, wenn das Bauelement geöffnet und nicht fehlerhaft ist, wobei die Dioden während der gesamten Halbperioden gelöscht bleiben, wenn das Bauelement fehlerhaft und kurzgeschlossen ist, dadurch gekennzeichnet, daß dieses Paar mit einer Reihenschaltung (R1, C) des RC-Typs in Reihe geschaltet ist, wobei die Gesamtheit aus den Dioden (D1, D2) und der RC-Schaltung (R1, C) zu dem Halbleiterbauelement (Th1, Th2) parallelgeschaltet ist, wobei die Dioden während eines kurzen Moments beim Nulldurchgang der Halbperioden erleuchtet werden, wenn das Bauelement geschlossen und nicht fehlerhaft ist.

2. Statisches Relais nach Anspruch 1, dadurch gekennzeichnet, daß der Halbleiter zwei Thyristoren (Th1, Th2) umfaßt.

3. Statisches Relais nach Anspruch 1, dadurch gekennzeichnet, daß der Halbleiter ein Triac ist.

4. Statisches Relais nach Anspruch 2, dadurch gekennzeichnet, daß es zwei Thyristoren (Th1, Th2) umfaßt, die zu den Anschlußklemmen des Relais parallel und zueinander entgegengesetzt geschaltet sind.

5. Statisches Relais nach einem der Ansprüche 1 bis 4, dadurch gekennzeichnet, daß es mit einer Steuerschaltung (CD) des Halbleiters (Th1, Th2) ausgerüstet ist, derart, daß der Halbeiter getriggert wird, wenn die Spannung an den Anschlußklemmen des Relais im wesentlichen auf 0 Volt übergeht.

6. Statisches Relais nach einem der Ansprüche 1 bis 5, dadurch gekennzeichnet, daß zu der Untergesamtheit, die aus den Elektrolumineszenz-Dioden (D1, D2) und dem Widerstand (R1) der Schaltung des RC-Typs gebildet ist, ein Spannungsbegrenzer (Z1, Z2) parallelgeschaltet ist.

7. Statisches Relais nach Anspruch 6, dadurch gekennzeichnet, daß der Begrenzer zwei Zener-Dioden (Z1, Z2) umfaßt, die in Reihe und zueinander entgegengesetzt geschaltet sind.

8. Statisches Relais nach einem der Ansprüche 1 bis 7, dadurch gekennzeichnet, daß die Kollektoren der Transistoren (T1, T2) miteinander verbunden sind (6) und einerseits über einen Widerstand (R2) an eine Versorgungsspannung (Vcc) und andererseits über einen Kondensator (C2) mit einer gemeinsamen Masse (M) verbunden sind, wobei die Emitter der Transistoren (T1, T2) mit der gemeinsamen Masse (M) verbunden sind.

9. Statisches Relais nach einem der Ansprüche 1 bis 7, dadurch gekennzeichnet, daß der Kollektor jedes Transistors (T1, T2) einerseits über einen Widerstand (R2, R'2) mit der Versorgungsspannung (Vcc) und andererseits über einen Kondensator (C2, C'2) mit einer gemeinsamen Masse (M) verbunden ist, wobei die Emitter der Transistoren (T1, T2) mit der gemeinsamen Masse (M) verbunden sind.

10. Statisches Relais nach einem der Ansprüche 1 bis 9, dadurch gekennzeichnet, daß das statische Relais mit einem System (BS) ausgerüstet ist, das die Formung und/oder die Übertragung von Zustandsinformationen (S1, S2, S3) des Relais zur äußeren Umgebung des Relais (RS) ausführt.

**Claims**

1. Static relay (RS) which is intended to be inserted into an A.C. electric circuit (CE) comprising at least two connection terminals (1, 2), the static relay (RS) having at least one semiconductor component able to take two states during the operating phase, one open and the other closed, means for determining the state of the relay (RS) during the operating phase and an additional state corresponding in particular to the relay destroyed, to the electric circuit (CE) deenergized, to the relay disconnected, these means being wired to the terminals of the relay and comprising a pair of light-emitting diodes (D1, D2) mounted in parallel head-to-tail, each diode (D1, D2) being optically coupled respectively to a transistor (T1, T2), one of the diodes being traversed by a current related to the positive half-cycle of the A.C. voltage of the electric circuit and the other diode being traversed by a current related to the negative half-cycle of the same electric circuit, the light-emitting diodes being lit for almost the entirety of the half-cycles when the component is open and non-defective, the diodes remaining unlit during the entirety of the half-cycles when the component is defective and short-circuited, characterized in that this pair is in series with a circuit of the series RC type (R1, C), the assembly of the diodes (D1, D2) and the RC circuit (R1, C) being wired in parallel with the semiconductor component (Th1, Th2), the diodes being lit for a short instant when the half-cycles pass through the zero level with the component being closed and non-defective.

2. Static relay according to Claim 1, characterized in that the semiconductor comprises two thyristors (Th1, Th2).

3. Static relay according to Claim 1, characterized in that the semiconductor is a triac.

4. Static relay according to Claim 2, characterized in that it comprises two thyristors (Th1, Th2) wired in parallel head-to-tail to the terminals of the relay.

5. Static relay according to any one of Claims 1 to 4, characterized in that it is equipped with a circuit (CD) for controlling the semiconductor (Th1, Th2) in such a way as to trigger the semiconductor when the voltage at the terminals of the relay goes substantially to 0 volts.

6. Static relay according to any one of Claims 1 to 5, characterized in that a voltage limiter (Z1, Z2) is connected in parallel with the subassembly formed by the light-emitting diodes (D1, D2) and the resistor (R1) of the RC type circuit.

7. Static relay according to Claim 6, characterized in that the limiter comprises two Zener diodes (Z1, Z2) mounted in series head-to-tail.

8. Static relay according to any one of Claims 1 to 7, characterized in that the collectors of the transistors (T1, T2) are wired together (6) and linked on the one hand to a supply voltage (Vcc) by way of a resistor (R2) and on the other hand to a common earth (M) by way of a capacitor (C2), the emitters of the transistors (T1, T2) being wired to the common earth (M) .

9. Static relay according to any one of Claims 1 to 7, characterized in that the collector of each transistor (T1, T2) is linked on the one hand to the supply voltage (Vcc) by way of a resistor (R2, R'2) and on the other hand to a common earth (M) by way of a capacitor (C2, C'2), the emitters of the transistors (T1, T2) being wired to the common earth (M).

10. Static relay according to any one of Claims 1 to 9, characterized in that the static relay is equipped with a system (BS) which shapes and/or transmits out of the relay (RS) the state information (S1, S2, S3) for the relay.

FIG.1a

FIG.1b

FIG.1c

FIG.2a

FIG.2b

FIG.2c

FIG.3a

FIG.3b

FIG.3c

FIG.4a

FIG.4b

FIG.5a

FIG.5b

FIG.5c